(19) **Europäisches Patentamt**

**European Patent Office**

**Office européen des brevets**

(11) **EP 0 806 735 B1**

(12) **EUROPEAN PATENT SPECIFICATION**

(45) Date of publication and mention
of the grant of the patent:
**26.03.2003 Bulletin 2003/13**

(51) Int Cl.⁷: $G06F\ 17/50$

(21) Application number: **96107107.3**

(22) Date of filing: **06.05.1996**

(54) **Method for control of a process flow according to a specified behavior with a computer**

Verfahren zur Steuerung eines Prozessablaufs nach von einem Rechner spezifizierten Verhalten

Méthode pour le contrôle d'un déroulement de processus selon un comportement spécifié par ordinateur

(84) Designated Contracting States:
**AT CH DE FR GB IT LI**

(43) Date of publication of application:
**12.11.1997 Bulletin 1997/46**

(73) Proprietor: **SIEMENS AKTIENGESELLSCHAFT**
**80333 München (DE)**

(72) Inventor: **Brandin, Bertil, Dr.**
**80469 München (DE)**

(56) References cited:
**EP-A- 0 445 942**     **EP-A- 0 577 298**

• IEEE TRANSACTIONS ON AUTOMATIC CONTROL, vol. 39, no. 2, February 1994, NEW YORK US, pages 329-342, XP000605069 BRANDIN ET AL: "supervisory control of timed discrete-event systems"
• COMPUTER AIDED VERIFICATION 7TH INTERNATIONAL CONFERENCE CAV 95 PROCEEDINGS, 3 July 1995, LIEGE BELGIUM, pages 279-292, XP000604449 AZIZ ET AL: "supervisory control of finite state machines"

**EP 0 806 735 B1**

## Description

The invention relates to automated process control including processes with specified time constraints.

Advances in automated manufacturing and trends towards the application of more computer implemented process controls, as well as the increase of the size of such implementations lead to even more complex and clumsy process-control-structures. In application fields such as automated production, complex layered communication-protocols, like in ISDN, or Video on demand, computer communication, internal processor busses, transportation systems, or object communication in object oriented programs, time requirements get more and more important and, caused by the complexity of the problems, urge the need for a suitable method of description or modelling of such process-flows. The goal is to model and analyse such processes automatically in order to achieve a description level where in a further step the process flow controller can be generated automatically and the process itself can be controlled without the need of intensive programming and evaluation efforts.

Several approaches have been made to this subject. The most recent known one state of the art is described in B. A. Brandin, W. M. Wonham, "The supervisory control of timed discrete-event systems", IEEE Transactions on Automatic Control, February 1994, pp. 329-342. There a modelling method is shown using timed state based processes, automatons, as modelling parts of processes to be modelled. Time units called "ticks" are used to show the inter dependencies of the automatons. It can be easily conceived from this document, that although establishing time constraints like upper- and lower time-bounds, while using ticks and automatons for modelling, even small automatons with few possible activities and few state transitions lead to fairly complex activity transition graphs. In order to establish a model of a more complex process-flow, these activity transition graphs have to be composed in one global process model, which ends up in a very large ununderstandable control-structure as shown for example in Figure 20.

The synthesis of such models in order to derive a supervisor, a so called automaton, which includes all the possible and all the allowed activities and state transitions within the process control structure, is an even more tedious task, because these bulky structures have to be handled correctly.

Thus it is an object of the invention to provide a Method for control of a process flow according to a specified behaviour with a computer, which leads to smaller and more user transparent process-models and to provide a method to automatically generate a supervisor control.
A further object of the invention is to include the treatment of specified time constraints in the automated generation of supervisor controls.
A further object of the invention is to omit "ticks" as time units.
A further object of the invention is to ease development and analysis of process-control of complex technical processes.
A further object of the invention is to provide a manufacturing process for a process-control of complex technical processes.

These objects are solved according to the invention claimed in claim one.

Preferable embodiments of the invention are claimed in the dependant claims.

The invention has the advantage, that it delivers automatically computer generated complete models of very complex process flows, which are compact and correct in terms of the specified process characteristics.

The invention has the further advantage, that it provides a new treatment of time constraints, which enables the modelling method to deal with activities instead of dealing with "ticks" and thus provides a tremendous amount of compaction as compared to the state of the art.

The invention has the further advantage, that it can be easily used to model process flows in any of the above mentioned technical fields and other similar fields known to a person skilled in the art and that due to the invention complex processes can be analysed and their supervising controller can be generated automatically.

The invention has the further advantage, that it provides a suitable way for the modelling and controlling method to be implemented as a very efficient computer executable process .

The invention has the further advantage, that it delivers the computer generated data in such fashion, that they can be automatically converted into activity transition graphs.

The invention has the further advantage, that it enables automated coding of process-controls.

The invention has the further advantage, that it reduces the necessary amount of work to establish a process controller.

The invention has the advantage, that for the first time it enables the modelling and analysis of very complex processes.

The invention has the advantage, that it enables the very compact modelling of timed state based processes, and the efficient synthesis and verification of supervisory control strategies (supervisors) for timed state based processes which guarantee maximally permissive process behaviours within given specifications.

The invention has the advantage, that it has long term potential since it provides a practical and unavoidable solution to the development of real time supervisory control systems for timed state based processes.

Advantageously the invention guarantees cost reduction in the development of control systems through (a) new computer aided development tools such as user interfaces, synthesis tools, verification tools, and automated coding tools, and (b) their application to both nominal behaviours such as part routing and to other behaviours such as error recovery, emergency shutdowns, testing procedures, and manual operations.

The invention has the further advantages, that it provides the very compact modelling of timed state based processes, as well as the efficient synthesis and verification of optimal supervisory control strategies for timed state based processes, and that the supervisory control strategies obtained are guaranteed by construction to restrict the processes real time behaviour within given behavioural specifications, as well as the supervisory control strategies obtained are guaranteed by construction to be maximally permissive within given behavioural specifications, also the processes restricted real time behaviour obtained is guaranteed to be nonblocking and the invention enables automated coding of supervisory control strategies in industrial control systems.

In the following part of the description the invention is further disclosed using equations and figures.

Figure 1 illustrates the relation between $\Sigma$, $\Sigma_u$, $\Sigma_c$ and $\Sigma_f$ ;
Figure 2 illustrates two vehicles $V_1$ and $V_2$;
Figure 3 illustrates the timed behavior of the two vehicles traveling concurrently;
Figure 4 illustrates a specification on the behavior of the two vehicles;
Figure 5 illustrates the supervisor or restricted timed behavior of the two vehicle traveling concurrently;
Figure 6 illustrates a manufacturing cell;
Figure 7 illustrates the timed behavior of two machines working concurrently;
Figure 8 illustrates a specification on the behavior of the two machines; and
Figure 9 illustrates the supervisor of restricted timed behavior of the two machines working concurrently.

## 1 Notation

Let $A$ and $B$ be arbitrary sets. Let $a$ be an element of $A$. $a \in A$ denotes $a$ is in $A$. $A \times B$ denotes the Cartesian product of $A$ and $B$. $|A|$ denotes the cardinality of $A$, i.e. the number of objects in $A$. Let $A$ be an arbitrary set of indexed objects $a_i$, $i \in I$, with $I$ denoting the corresponding index set. $\Pi_{i \in I} a_i$ denotes the Cartesian product of the objects $a_i \in A$ over the index set $I$. Let $A$ and $B$ be two arbitrary subsets of a set $C$ of objects. $A \subseteq C$ denotes set inclusion, and $A \subset C$ denotes strict set inclusion. $A \cup B$ denotes set union, and $A \dot\cup B$ denotes the union of disjoint sets. Let $A_i$, $i \in I$ be arbitrary indexed subsets of a set $C$ of objects, with $I$ denoting the corresponding index set. $\cup_{i \in I} A_i$ denotes the set union of the subsets $A_i$ over the index set $I$. $A \cap B$ denotes set intersection.

Let $\infty$ denote infinity. Let **N** denote the natural numbers $\{0,1,2,...\}$. For $a, b \in N \dot\cup \{\infty\}$ and $a$ and $b$ not simultaneously $\infty$, define $a-b = \max(0, a - b)$.

Let $\vee$ denote the logical disjunction operator (or), $\wedge$ denote the logical disjunction operator (and), $\neg$ denote the logical negation operator (not), $\forall x$ denote the universal quantifier, $\exists x$ denote the existential quantifier.

An *automaton* (or *finite state machine)* G is given by G = $(\Sigma,Q,\delta,q_0,Q_m)$ in which $\Sigma$ is an *alphabet,* $Q = \{q_0, q_1,...\}$ is the *state set* (assumed finite and nonempty), $\delta : Q \times \Sigma \to Q$ is the *transition function,* $q_0 \in Q$ is the initial state and $Q_m \subseteq Q$ is the *marked state set.* Let the transition function $\delta : Q \times \Sigma \to Q$ be defined at each $q \in Q$ only for a subset of the elements $\sigma \in \Sigma$; namely $\delta$ is a partial function. The notation $\delta(\sigma, q)!$ will mean that $\delta(\sigma, q)$ is defined. *The events* in a state based process modeled by the automaton **G** constitute the alphabet $\Sigma$, and are state transitions from a state $q_i \in Q$ to a state $q_j \in Q$ for which $\delta$ is defined.

Let G = $(\Sigma,Q,\delta,q_0,Q_m)$ be an automaton. In order to represent $G$, $Q$ may be identified with the nodes of a directed graph $G$ whose edges are labeled with symbols $\sigma \in \Sigma$; namely $(q, \sigma, q')$ is a labeled edge

$$q \circ \xrightarrow{\sigma} \circ q'$$

of $G$, if and only if $\delta(\sigma, q) = q'$. Such a graph is a *state transition graph* for **G**. In $G$ we attach to $q_0$ an entering arrow as in $\to \circ q_0$, and marker states $q \in Q_m$ are represented as in $q\bullet$.

## 2 Modelling

In order to model the timed behavior a timed state based process we start with

(i) an automaton (or finite state machine) **A** = $(\Sigma,A,\delta_A,a_o,A_m)$ representing the untimed behavior of the state based process. $\Sigma$ is a finite alphabet of event labels (or simply events). *A* represents an activity set whose elements are activities *a*. Here we shall restrict $A$ to be finite. In the interpretation of **A** considered here, activities have duration in time, while events are instantaneous. The activity transition function $\delta_A$ is a partial function $\delta_A : A \times \Sigma \to A$. $a_o$

is the initial activity and $A_m \subseteq A$ is the subset of marker activities. These are activities which have a particular meaning from a control perspective, such as for example, the end of a machine work cycle.

(ii) together with *default lower* and *upper time bounds* for the events $\sigma \in \Sigma$. Let **N** denote the natural numbers $\{0,1,2,...,\}$. Each event label $\sigma \in \Sigma$ will be equipped with a default lower time bound $l_\sigma \in$ **N**, and a default upper time bound $u_\sigma \in$ N$\cup\{\infty\}$, with $l_\sigma \leq u_\sigma$.

From the automaton **A** above and the corresponding default lower and upper time bounds, we model the timed behavior of the timed state based process considered with the automaton **E** = $(\Sigma, E, \delta_E, e_o, E_m)$. $\Sigma$ is the finite alphabet of event labels in **A** above. $E$ represents the timed activity set whose elements are *timed activities e.* As for $A$ above, $E$ is restricted to be finite. The activity transition function $\delta_E$ is a partial function $\delta_E : E \times \Sigma \to$ E. $e_o$ is the initial timed activity and $E_m \subseteq E$ is the subset of marker timed activities. As for $A_m$ above, these are timed activities which have a particular meaning from a control perspective.

The automaton **E** = $(\Sigma, E, \delta_E, e_o, E_m)$ is now defined.

For $j, k \in$ **N** write $[j, k]$ for the set of integers $i$ with $j \leq i \leq k$ and let for $\sigma \in \Sigma$

$$T_\sigma = \begin{cases} [0, u_\sigma] & \text{if} \quad u_\sigma \neq \infty \\ \{\infty\} & \text{if} \quad u_\sigma = \infty \end{cases}$$

$$R_\sigma = [0, l_\sigma].$$

The *timed activity set E is* given by $E = A \times \Pi_{\sigma \in \Sigma}(R_\sigma \times T_\sigma)$. Therefore, a timed activity is an element of the form

$$e = (a, \{(r_\sigma, t_\sigma) \text{ such that } \sigma \in \Sigma\})$$

where $a \in A, r_\sigma \in R_\sigma$ and $t_\sigma \in T_\sigma$; namely, $e$ consists of an activity together with $n$ integer pairs, where $n$ is the number of events $\sigma$ in $\Sigma$. $r_\sigma$ will be called the *lower-bound timer* of $\sigma$ in the timed activity $e$, and similarly $t_\sigma$ will be called the *upper-bound timer* of $\sigma$ in the timed activity $e$. $r_\sigma$ represents the delay to the earliest possible occurrence of $\sigma$ from the activity $a$. $t_\sigma$ represents the delay to the latest possible occurrence of $\sigma$ from the activity $a$ (possibly infinity). The initial timed activity is given by

$$e_o = (a_o, \{(l_\sigma, u_\sigma) \text{ such that } \sigma \in \Sigma\}).$$

The marker timed activity subset will be taken to be of the form

$$E_m \subseteq A_m \times \prod_{\sigma \in \Sigma}(R_\sigma \times T_\sigma).$$

We now provide the formal definition of $\delta_E$. Write $\delta_E(e, \sigma) = e'$, with

$$e = (a, \{(r_\tau, t_\tau) \text{ such that } \tau \in \Sigma\}),$$

$$e' = (a', \{(r'_\tau, t'_\tau) \text{ such that } \tau \in \Sigma\}).$$

$\delta_E$ is defined for $\sigma \in \Sigma$ at $e$ if and only if $\sigma$ is defined from $a$ and there does not exist an other event $\alpha \in \Sigma$ defined from $a$ whose upper time bound is strictly smaller than the lower time bound of $\sigma$:

$$\delta_E(e, \sigma)! \text{ if and only if } \delta_A(a, \sigma)! \text{ and } (\neg\exists\alpha \in \Sigma_A)(\alpha \neq \sigma \wedge \delta_A(a, \alpha)! \wedge t_\alpha < r_\sigma).$$

The activity $e' = (a', \{(r'_\tau, t'_\tau) \text{ such that } \tau \in \Sigma\})$ is then defined as follows: $a' = \delta_A(a, \sigma)$ and

(i) if $\tau \neq \sigma$

$$(r'_\tau, t'_\tau) = \begin{cases} (r_\tau \dot{-} t_\sigma, t_\tau \dot{-} r_\sigma) & \text{if } \delta_A(a, \tau)! \wedge \delta_A(a', \tau)! \\ (l_\tau, u_\tau) & \text{otherwise} \end{cases}$$

(ii) if $\tau = \sigma$

$$(r'_\tau, t'_\tau) = (l_\tau, u_\tau).$$

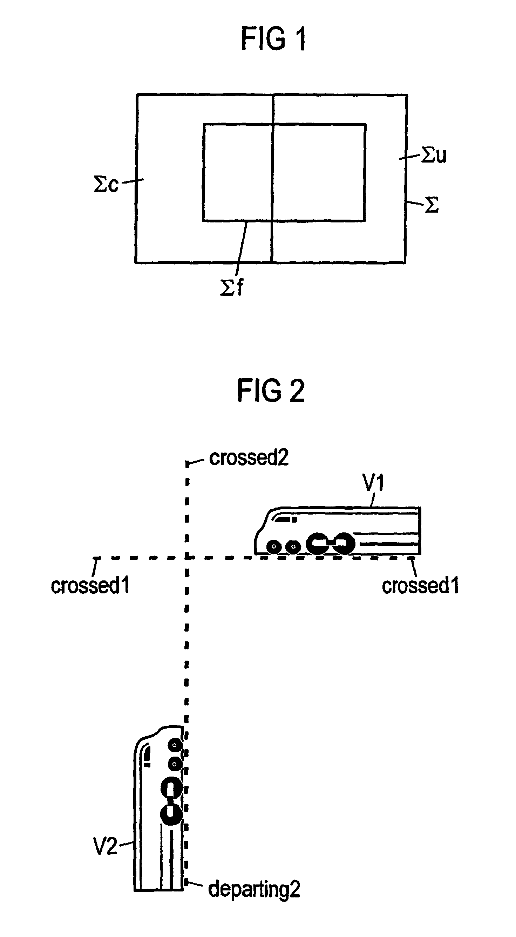

The events $\sigma \in \Sigma$ are divided in uncontrollable, controllable and forcible events. The subset of uncontrollable events is denoted $\Sigma_u$. These are events which occur spontaneously within the corresponding time interval, and whose occurrence may not be disabled through control. The subset of controllable events is denoted $\Sigma_c$. These are events which may be preempted indefinitely from occurring through control, i.e. their occurrence may be disabled through control. Their upper time bounds is therefore always infinity. If not disabled, controllable events will occur within the corresponding time interval. The subset of forcible events is denoted $\Sigma_f$. Forcible events may either be uncontrollable or controllable. These are events that may be forced to occur through control any time during the corresponding time interval. Figure 1 illustrates the relation between $\Sigma$, $\Sigma_u$, $\Sigma_c$, and $\Sigma_f$.

## 3 Composition

In order to model the timed behavior of a number of timed based processes working in parallel, composition is required and is now presented.

Given a number of automata $\mathbf{A}_i = (\Sigma_i, A_i, \delta A_i, a_{o,i}, A_{m,i})$, $i = 1, ..., n$ representing the untimed behavior of corresponding timed state based processes, one single automaton $\mathbf{A} = (\Sigma_A, A, \delta_A, a_o, A_m)$ embodying the synchronized untimed behavior of the automata $A_i$, $i = 1,..., n$ is obtained as follows:

$$\Sigma_A = \bigcup_{i=1,...,n} \Sigma_i,$$

$$A = \prod_{i=1,...,n} A_i,$$

$$a_o = (a_{o,1}, ..., a_{o,n}),$$

$$A_m = \prod_{i=1,...,n} A_{m,i},$$

and

where $\delta_A : A \times \Sigma_A \to A$ is now defined. Let $\sigma \in \Sigma_A$. Write $\delta_A(a, \sigma) = a'$ with

$$a = (a_1,...,a_n),$$

$$a' = (a'_1, ..., a'_n).$$

Then $\delta_A(a, \sigma)$ is defined if and only if for $i = 1,..., n$ either $\delta_{A_i}(a_i, \sigma)$ is defined or $\sigma$ is not in $\Sigma_i$:

$$\delta_A(a, \sigma)! \text{ if and only if } (\delta_{A_i}(a_i, \sigma)! \vee \sigma \notin \Sigma_i), i = 1,..., n.$$

The activity $a' = (a'_1, ..., a'_n)$ is then given by: for $i = 1,..., n$

$$a'_i \;=\; \begin{cases} \delta_{A_i}(a_i, \sigma) & \text{if } \delta_{A_i}(a_i, \sigma)! \\ a_i & \text{otherwise.} \end{cases}$$

For further reference we will denote the synchronous composition of $\mathbf{A}_i$, $i = 1,..., n$ into $\mathbf{A}$, by $\mathbf{A} = (\Sigma_A, A, \delta_A, a_o, A_m) = composition(\mathbf{A}_1, ..., \mathbf{A}_n)$.

Having composed the various $\mathbf{A}_i$, $i = 1,..., n$ into $\mathbf{A}$, and given the default lower and upper time bounds of the events $\sigma \in \Sigma_A$, the timed behavior $\mathbf{E}$ is obtained as described above in Section 2 above.

Note: It is assumed that any event $\sigma \in \Sigma_A$ has unique default lower and upper time bounds $(l_\sigma, u_\sigma)$, even if $\sigma$ is shared by two or more alphabets $\Sigma_i$, $i \in \{1,...,n\}$.

## 4 Model construction algorithm

While Sections 2 and 3 define the timed behavior $\mathbf{E}$ of given timed state based processes modeled by a number of automata $\mathbf{A}_i$, $i = 1,..., n$ and the corresponding event default lower and upper time bounds, the present Section provides the algorithm to construct $\mathbf{E}$ from $\mathbf{A}_i$, $i = 1,..., n$ and the corresponding event default lower and upper time bounds.

(1) Initialisation.

For further reference we define four sets (i) the *new set*, (ii) the *final set*, (iii) the *marker set*, and (iv) the *transitions set,* all of which are assumed initially empty. We consider the initial timed activity

$$e_o = (a_o, \{(l_\sigma, u_\sigma) \text{ such that } \sigma \in \Sigma\}) \text{ with } a_o = (a_{o,1}, ..., a_{o,n})$$

Let

$$e = (a, \{(r_\sigma, t_\sigma) \text{ such that } \sigma \in \Sigma\}) \text{ with } a = (a_1, ..., a_n).$$

$$= e_o.$$

We add $e$ to the new set. Furthermore, if all the activities $a_i$, $i = 1, ..., n$ composing $a$ are marker activities, i.e. $a_i \in A_{m,i}$, $i = 1, ..., n$, we add $e$ to the marker set.

(2) Timed activities construction.

Let $e = (a, \{(r_\sigma, t_\sigma) \text{ such that } \sigma \in \Sigma\})$ with $a = (a_1,..., a_n)$.

$e$ is removed from the new set and is placed in the final set.

For all the events $\sigma \in \Sigma$ such that $\delta_E(e, \sigma)$ is defined we compute the corresponding timed activity $\delta(e, \sigma) = e'$ reached from $e$ by $\sigma$.

Recall that $\delta_E(e,\sigma)$ is defined if and only if (i) $\delta_A(a,\sigma)$ is defined, and (ii) there does not exist an other event $\alpha \in \Sigma$ such that $\delta_A(a,\alpha)$ is defined and whose upper time bound $t_\alpha$ is strictly smaller than the lower time bound $r_\sigma$ of $\sigma$.

Let $e' = (a', \{(r_\tau, t'_\tau) \text{ such that } \tau \in \Sigma\})$ with $a' = (a'_1,...,a'_n)$.

*a'* is computed as follows: for *i* = 1, ..., *n*

$$a'_i = \begin{cases} \delta_{A_i}(a_i, \sigma) & \text{if } \delta_{A_i}(a_i, \sigma)! \\ a_i & \text{otherwise.} \end{cases}$$

The lower and upper time bounds $(r'_\tau, t'_\tau)$, $\tau \in \Sigma$ are computed as follows:

if $\tau \neq \sigma$

$$(r'_\tau, t'_\tau) = \begin{cases} (r_\tau \dot{-} t_\sigma, t_\tau \dot{-} r_\sigma) & \text{if } \delta_A(a, \tau)! \wedge \delta_A(a', \tau)! \\ (l_\tau, u_\tau) & \text{otherwise} \end{cases}$$

if $\tau = \sigma$

$$(r'_\tau, t'_\tau) = (l_\tau, u_\tau).$$

Then, (i) if *e'* is not in the final set, we add *e'* to the new set, and if all the activities $a'_i$, *i* = 1,..., *n* composing *a'* are marker activities, i.e. $a'_i \in A_{m,i}$, *i* = 1, ..., *n*, we add *e'* to the marker set; (ii) the transition $(e, \sigma, e')$ is added to the transitions set.

(3) Timed activities construction loop.

We consider in turn all the timed activities in the new set and repeat steps (2) to (3) until the new set is empty.
Then, for the automaton $\mathbf{E} = (\Sigma, E, \delta_E, e_o, E_m)$ we have $\Sigma$ given as above, and

$E =$     final set
$\delta_E =$     transitions set
$e_o =$     $(a_o, \{(l_\sigma, u_\sigma) \text{ such that } \sigma \in \Sigma\})$ with $a_o = (a_{o,1},...,a_{o,n})$
$E_m =$     marker set.

**Modeling example 1: Traffic system**

The timed behavior of two vehicles crossing an intersection is modeled below. The two vehicles $V_1$, $V_2$ are shown in Figure 2. We are given for Vehicle1:

$$A_1 = (\Sigma_1, A_1, \delta_{A_1}, a_{o,1}, A_{m,1})$$

$A_1 =$     $\{departing_1, crossed_1\}$
$\delta_{A_1} =$     $\{(departure_1, pass_1, crossed_1)\}$
$a_{o,1} =$     $departing_1$
$A_{m,1} =$     $\{crossed_1\}$

together with the following default lower and upper time bounds $(l_{pass_1}, u_{pass_1}) = (8, 10)$. We are given for Vehicle2:

$$A_2 = (\Sigma_2, A_2, \delta_{A_2}, a_{o,2}, A_{m,2})$$

$A_2 =$     $\{departing_2, crossed_2\}$

$$\delta_{A2} = \{(departure_2, pass_2, crossed_2)\}$$
$$a_{o,2} = departing_2$$
$$A_{m,2} = \{crossed_2\}$$

together with the following default lower and upper time bounds $(l_{pass2}, u_{pass2}) = (5, \infty)$.

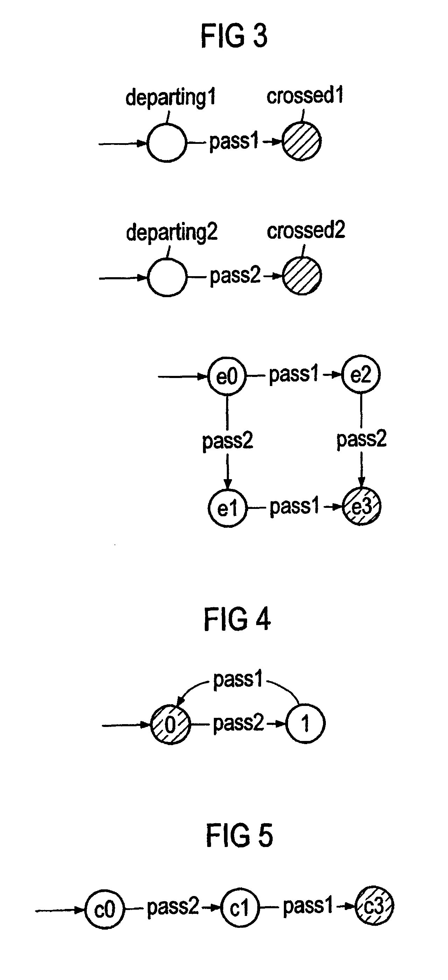

The corresponding timed behavior **E** of the two vehicles traveling concurrently is obtained according to the procedure presented in Section 4, and is shown in Figure 3.

$$E = (\Sigma, E, \delta_E, e_o, E_m)$$

$$\Sigma = \{pass_1, pass_2\}$$

$$E = \{e_o, e_1, e_2, e_3\}$$

where

$$e_o = ((departing_1, departing_2), (8, 10)(5, \infty))$$
$$e_1 = ((departing_1, crossed_2), (0, 5)(5, \infty))$$
$$e_2 = ((crossed_1, departing_2), (8, 10)(0, \infty))$$
$$e_3 = ((crossed_1, crossed_2), (8, 10)(5, \infty))$$
$$\delta_E = \{(e_o, pass_1, e_2), (e_o, pass_2, e_1), (e_1, pass_1, e_3), (e_2, pass_2, e_3)\}$$
$$e_o = ((departing_1, departing_2), (8, 10)(5, \infty))$$
$$E_m = \{((crossed_1, crossed_2), (8, 10)(5, \infty))\}$$

It is important to note that the present model has 4 timed activities and 4 transitions versus 19 states and 30 transition using the state of the art.

## Modeling example 2: A two-machine manufacturing cell

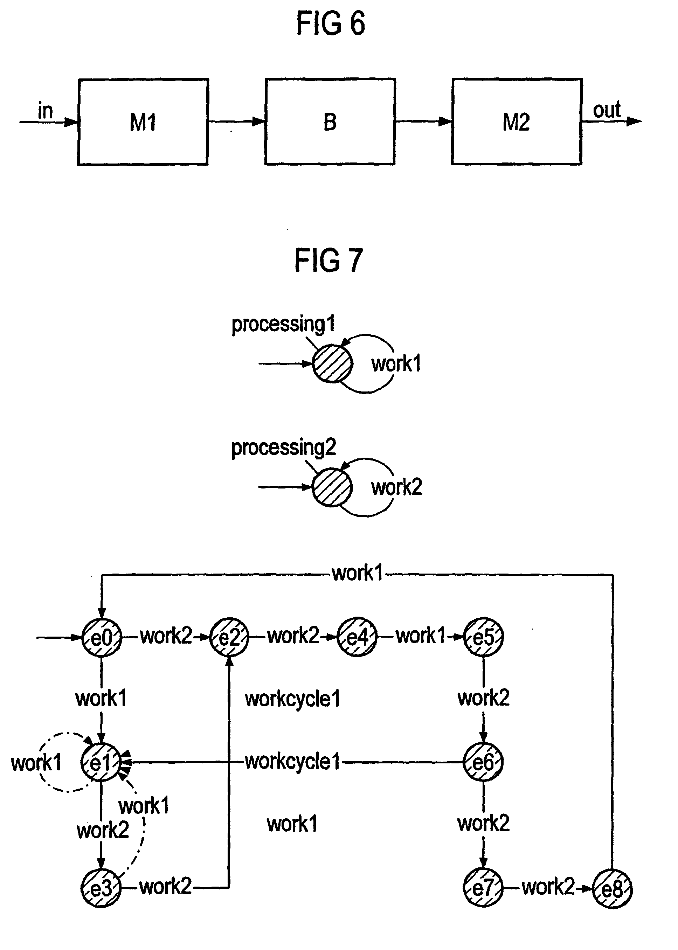

The timed behavior of two machines constituting a manufacturing cell is modeled below. The cell is shown in Figure 6. We are given for Machine1:

$$A_1 = (\Sigma_1, A_1, \delta_{A_1}, a_{o,1}, A_{m,1})$$

$$A_1 = \{processing_1\}$$
$$\delta_{A_1} = \{(operational_1, work_1, operational_1)\}$$
$$a_{o,1} = operational_1$$
$$A_{m,1} = \{operational_1\}$$

together with the following default lower and upper time bounds $(l_{work_1}, u_{work_1}) = (5, 5)$. We are given for Machine2:

$$A_2 = (\Sigma_2, A_2, \delta_{A_2}, a_{o,2}, A_{m,2})$$

$$A_2 = \{processing_2\}$$
$$\delta_{A_2} = \{(operational_2, work_2, operational_2)\}$$
$$a_{o,2} = operational_2$$
$$A_{m,2} = \{operational_2\}$$

together with the following default lower and upper time bounds $(l_{work_2}, u_{work_2}) = (2, \infty)$.

The corresponding timed behavior **E** of the two machines working concurrently is obtained according to the procedure presented in Section 4, and is shown in Figure 7.

$$E = (\Sigma, E, \delta_E, e_o, E_m)$$

where

$$\Sigma = \{work_1, work_2\}$$

$$E = \{e_o, e_1, e_2, e_3, e_4, e_5, e_6, e_7, e_8\}$$

where

$e_o =$  $((operational_1, operational_2), (5,5) (2, \infty))$
$e_1 =$  $((operational_1, operational_2), (5, 5) (0, \infty))$
$e_2 =$  $((operational_1, operational_2), (0, 3)(2, \infty))$
$e_3 =$  $((operational_1, operational_2), (0, 5)(2, \infty))$
$e_4 =$  $((operational_1, operotional_2), (0, 1)(2, \infty))$
$e_5 =$  $((operational_1, operational_2), (5, 5)(1, \infty))$
$e_6 =$  $((operational_1, operational_2), (0, 4) (2, \infty))$
$e_7 =$  $((operational_1, operational_2), (0, 2)(2, \infty))$
$e_8 =$  $((operational_1, operational_2), (0, 0)(2, \infty))$
$\delta_E =$  $\{(e_o, work_1, e_1), (e_o, work_2, e_2),$
 $(e_1, work_2, e_3), (e_1, work_1, e_1),$
 $(e_2, work_1, e_4),$
 $(e_3, work_2, e_2), (e_3, work_1, e_1),$
 $(e_4, work_1, e_5),$
 $(e_5, work_2, e_6), (e_5, work_1, e_1),$
 $(e_6, work2, e_7), (e_6, work_1, e_1),$
 $(e_7, work_2, e_8), (e_7, work_1, e_1),$
 $(e_8, work_1, e_o)\}$
$e_o =$  $((operational_1, operational_2), (5,5)(2,\infty)),$
$E_m =$  $E.$

Again, it is important to note that the present model has 9 timed activities and 15 transitions versus 18 states and 24 transition using the state of the art.

### 5 Supervisor synthesis

Given an automaton **E** representing the timed behavior of given timed state based processes, we are able through control, to restrict such behavior within given behavioral specifications represented by automata.

The resulting restricted timed behavior is guaranteed by construction not to violate the specifications considered, to be maximally permissive within these, and to be nonblocking. Such restricted behavior is also represented in the form of an automaton. Nonblocking is taken here to mean that from any point in the restricted timed behavior considered, it must be possible to reach a point in the same behavior, with particular meaning from a control perspective, such as for example the end of a production cycle.

In order to guarantee that the timed behavior of the timed state based processes considered remains through control within given behavioral specifications, the following must apply: at any point in the behavior of the timed state based processes considered either

(i) any uncontrollable event which is physically possible must also be allowed by the specifications considered; or

(ii) there must exist a forcible event, both physically possible and allowed by the specifications, able to preempt the occurrence of any physically possible uncontrollable event not allowed by the specifications; or

(iii) it must be possible ahead of the point considered in the behavior, to prevent through disablement or forcing the behavior from reaching the point considered.

In order to guarantee that the timed behavior of the timed state based processes considered is nonblocking, the following must also apply:

(iv) from any point in the behavior considered, it must be possible to reach a point in behavior with particular meaning from a control perspective.

The synthesis algorithm presented in this Section enables the construction of the processes nonblocking and maximally permissive behavior within given specifications represented by automata. Based on disablement, condition (ii) and condition (iii) above, the timed behavior of the timed state based processes considered is restricted in order to guarantee that conditions (i) and (iv) above hold at any point of the restricted behavior. The restricted timed behavior is returned in the form of an automaton $C = (\Sigma, C, \delta_C, c_o, C_m)$, and is referred to as a supervisor. Note that the restricted behavior may be empty, signifying that it is impossible to satisfy the specifications considered.

Assume given

(i) a number of automata $A_i = (\Sigma_i, A_i, \delta_{A_i}, a_{o,i}, A_{m,i})$, $i = 1,..., n$ representing the untimed behavior of corresponding timed state based processes,

(ii) the corresponding event default lower and upper time bounds, and

(iii) a number of automata $A_i = (\Sigma_i, A_i, \delta_{A_i}, a_{o,i}, A_{m,i})$, $i = n + 1,..., m$ representing the specified and desired behavior of the timed state based processes considered, with the union of the desired behavior alphabets $\Sigma_i$, $i = n+1,..., m$ included in the union of the processes alphabets $\Sigma_i$, $i = 1,..., n$, i.e. $\cup_{i=n+1,...,m} \Sigma_i \subseteq \cup_{i=1,...,n} \Sigma_i$.

Let $E = (\Sigma, E, \delta_E, e_o, E_m)$ be defined as described in Section 2 from $A = (\Sigma_A, A, \delta_A, a_o, A_m) = composition$ $(A_1,...,A_n)$ and the corresponding time bounds. Let $B = (\Sigma_B, B, \delta_B, B_o, B_m) = compostion(A_{n+1}..., A_m)$.

The behavior embodied by $C$ is a subset of the behavior embodied by the synchronous composition of $E$ and $B$. Therefore, we have for $C = (\Sigma, C, \delta_C, c_o, C_m)$

$$\Sigma = \bigcup_{i=1,...,n} \Sigma_i$$

$$C \subseteq E \times B$$

$$\delta_C : C \times E \to C$$

$$c_o = (e_o, b_o)$$

$$C_m \subseteq E_m \times B_m.$$

The supervisor synthesis algorithm is now presented.

(1) Initialisation.

For further reference we define six sets (i) the *new set*, (ii) the *final set,* (iii) the *bad set,* (iv) the *marker set,* (v) the *nonblocking set,* and (vi) the *transitions set*, all of which are assumed empty initially.

We consider the initial timed activity

$$c_o = (e_o, b_o)$$

$$= ((a_{o,1},...,a_{o,n}),\{(l_\sigma, u_\sigma) \text{ such that } \sigma \in \Sigma\}, (a_{o,n+1},...,a_{o,m})).$$

Let

$$c = (e,b)$$

$$c = ((a_1,...,a_n),\{(r_\sigma,t_\sigma) \text{ such that } \sigma \in \Sigma\}, (a_{n+1},...,a_m))$$

$$= c_o.$$

We place $c$ in the new set. Furthermore, if all the activities $a_i$, $i = 1,...,n$ composing a are marker activities, i. e. $a_i \in A_{m,i}$, $i = 1,...,n$, we add $e$ to the marker and nonblocking sets.

(2) Physically possible and legal sets construction.

Let $c = (e, b) = ((a_1,...,a_m),\{(r_\sigma,t_\sigma) \text{ such that } \sigma \in \Sigma\}, (a_{n+1},...,a_m))$.
For $e$ determine the set of events $\sigma \in \Sigma$ such that $\delta_A(a,\sigma)$ is defined. For convenience, refer to this set of events as the *physically possible event set* of $c$. Recall that *these are the events* for which (i) $\delta_A(a, \sigma)$ is defined and for which (ii) there does not exist an other event $\alpha \in \Sigma$ such that $\delta_A(a, \alpha)$ is defined and whose upper time bound $t_\alpha$ is strictly smaller than the lower time bound $r_\sigma$ of $\sigma$.
For $b$ determine the set of events $\sigma \in \Sigma$ such that $\delta_B(b, \sigma)$ is defined. For convenience, refer to this set of events as the *legal event set* of $c$.

(3) Bad timed activities identification.

We remove the timed activity

$$c = (e,b) = ((a_1, ..., a_m), \{(r_\sigma, t_\sigma) \text{ such that } \sigma \in \Sigma\}, (a_{n+1}, ..., a_m))$$

from the new set.
If (i) either all uncontrollable events $\sigma$ in the physically possible event set of $c$ are contained in the legal event set of $c$, or (ii) if for all the uncontrollable events $\sigma$ in the physically possible event set of $c$ which are not contained in the legal event set of $c$, there exists a forcible event $\beta$ which is both in the physically possible event set of $c$ and in the legal event set of $c$, such that its lower time bound $r_\beta$ is strictly smaller than the lower time bound $r_\sigma$ of $\sigma$, we place $c = (e, b)$ in the final set of $\sigma$; otherwise we place $c$ in the bad set.

(4) Bad timed activities identification.

For all the timed activities $c$ in the bad set, we find the corresponding timed activities $c'$ in the final set from which $c$ may be reached in one transition $\sigma$.
If the transition $\sigma$ leading to $c$ from $c'$ is uncontrollable and there does not exist a forcible event $\beta$ in both the physically possible event set of $c$ and in the legal event set of $c$, such that its lower time bound $r_\beta$ is strictly smaller than the lower time bound $r_\sigma$ of $\sigma$, we remove the activity $c'$ from the marker, nonblocking and final sets and add it to the bad set, and remove the transition $(c',\sigma,c)$ from the transition set.
If the transition $\sigma$ leading to $c$ from $c'$ is uncontrollable and there exists a forcible event $\beta$ in both the physically possible event set of $c$ and in the legal event set of $c$ such that its lower time bound $r_\beta$ is strictly smaller than the lower time bound $r_\sigma$ of $\sigma$, $u_\beta$ is set so that $u_\beta$ is strictly smaller than $r_\sigma$.
If the transition $\sigma$ leading to $c$ from $c'$ is controllable, we remove the transition $(c', \sigma, c)$ from the transition set, thus disabling it.

(5) Bad timed activities identification loop.

Step 4 is repeated until the number of timed activities in the bad set remains invariant.

(6) Timed activities construction.

For all the timed activities $c$ in the final set and for all the events $\sigma$ contained in both the physically possible event set of $c$ and in the legal event set of c, we compute the corresponding timed activity $\delta(c, \sigma) = c'$.
Let $c' = (a',\{(r'_\tau,t'_\tau) \text{ such that } \tau \in \Sigma\},b')$ with $a' = (a'_1,...,a'_n)$ and $b' = (a'_{n+1}, ..., a'_m)$.
$a'$ is computed as follows: for $i = 1,...,n$

$$a'_i = \begin{cases} \delta_{A_i}(a_i, \sigma) & \text{if } \delta_{A_i}(a_i, \sigma)! \\ a_i & \text{otherwise.} \end{cases}$$

The lower and upper time bounds $(r'_\tau, t'_\tau)$, $\tau \in \Sigma$ are computed as follows:
if $\tau \neq \sigma$

$$(r'_\tau, t'_\tau) = \begin{cases} (r_\tau \dot{-} t_\sigma, t_\tau \dot{-} r_\sigma) & \text{if } \delta_A(a, \tau)! \wedge \delta_A(a', \tau)! \\ (l_\tau, u_\tau) & \text{otherwise} \end{cases}$$

if $\tau = \sigma$

$$(r'_\tau, t'_\tau) = (l_\tau, u_\tau).$$

$b'$ is computed as follows: for $i = n + 1, ..., m$

$$a'_i = \begin{cases} \delta_{A_i}(a_i, \sigma) & \text{if } \delta_{A_i}(a_i, \sigma)! \\ a_i & \text{otherwise.} \end{cases}$$

Then, (i) if $c'$ is not already in either the final set or in the bad set, we add $c'$ to the new set, and if all the activities $a_i$, $i = 1,..., m$ composing $a'$ and $b'$ are marker activities, i.e. $a'_i \in A_{m,i}$, $i = 1, ..., m$, we add $c'$ to the marker and nonblocking sets; (ii) the transition $(c, \sigma, c')$ is added to the transitions set.

(7) Timed activities construction loop.

Consider in turn all the timed activities in the new set and repeat steps (2) to (7) until the new set is empty.

(8) Nonblocking timed activities identification.

For all the timed activities $c$ in the nonblocking set, we find the corresponding timed activities $c'$ in the final set from which $c$ may be reached in one transition $\sigma$. We add $c'$ to the nonblocking set.

(9) Nonblocking timed activities identification loop.

Step 8 is repeated until the number of timed activities in the nonblocking set remains invariant.

(10) Blocking timed activities removal.

All the timed activities $c$ in the final set and not in the nonblocking set are removed from the marker and final sets and are placed in the bad set.

(11) Blocking timed activities removal.

For all the activities in the bad set, we find the corresponding timed activities $c'$ in the final set from which $c$ may be reached in one transition $\sigma$.
If the transition $\sigma$ leading to $c$ from $c'$ is uncontrollable and there does not exist a forcible event $\beta$ in both the physically possible event set of $c$ and in the legal event set of $c$, such that its lower time bound $r_\beta$ is strictly smaller than the lower time bound $r_\sigma$ of $\sigma$, we remove the activity $c'$ from the marker, nonblocking and final sets, and add it to the bad set, and remove the transition ($c'$, σ, $c$) from the transition set.

If the transition σ leading to $c$ from $c'$ is uncontrollable and there exists a forcible event β in both the physically possible event set of $c$ and in the legal event set of $c$, such that its lower time bound $r_\beta$ is strictly smaller than the lower time bound $r_\sigma$ of σ, $u_\beta$ is set so that $u_\beta$ is strictly smaller than $r_\sigma$.

If the transition σ leading to c from $c'$ is controllable, we remove the transition ($c'$, σ, $c$) from the transition set.

(12) Blocking activities identification loop.

Step 11 is repeated until the number of timed activities in the bad set remains invariant.

Then, for the automaton **C** = (Σ, $C$, $\delta_C$, $c_o$, $C_m$) we have Σ given as above, and

$C =$ final set
$\delta_C =$ transitions set
$e_o =$ ($a_o$, {($l_\sigma$, $u_\sigma$) such that σ ∈ Σ}, $b_o$)
with $a_o = (a_{o,1}, ..., a_{o,n})$, $b_o = (a_{o,n+1}, ..., a_{o,m})$
$C_m =$ marker set .

**Synthesis example 1: Traffic system**

Recall in the traffic system example of Section 4:

Vehicle1:

$$A_1 = (\Sigma_1, A_1, \delta_{A_1}, a_{o,1}, A_{m,1})$$

$A_1 =$ {$departing_1$, $crossed_1$}
$\delta_{A_1} =$ {($departure_1$, $pass_1$, $crossed_1$)}
$a_{o,1} =$ $departing_1$
$A_{m,1} =$ {$crossed_1$}

together with the following default lower and upper time bounds ($l_{pass_1}$, $u_{pass_1}$) = (8,10). $pass_1$ is furthermore assumed to be uncontrollable and non forcible.

Vehicle2:

$$A_2 = (\Sigma_2, A_2, \delta_{A_2}, \alpha_{0,2}, A_{m,2})$$

$A_2 =$ {$departing_2$, $crossed_2$}
$\delta_{A2} =$ {($departure_2$, $pass_2$, $crossed_2$)}
$a_{\sigma,2} =$ $departing_2$
$A_{m,2} =$ {$crossed_2$}

together with the following default lower and upper time bounds ($l_{pass_2}$, $u_{pass_2}$) = (5, ∞). $pass_2$ is furthermore assumed to be controllable and forcible.

We impose a specification on the behavior of the two vehicles: $vehicle_2$ must cross before the arrival of $vehicle_1$. This specification is embodied by the automaton **B** = **A**$_3$ and is shown in Figure 4.

$$A_3 = (\Sigma_3, A_3, \delta_{A_3}, a_{o,3}, A_{m,3})$$

$A_3 =$ {0,1}
$\delta_{A3} =$ {(0,$pass_2$,1),(1,$pass_1$,0)}
$a_{o,3} =$ 0
$A_{m,3} =$ {0}

The corresponding supervisor or restricted timed behavior **C** of the two vehicles traveling concurrently within the specifications **B** = **A**$_3$ is obtained according to the supervisor synthesis procedure presented in Section 5, and is shown in Figure 5.

$$C = (\Sigma, C, \delta_C, c_o, C_m)$$

$$\Sigma = \quad \{pass_1, pass_2\}$$

$$C = \{c_o, c_1, c_2\}$$

where

$e_o = \quad ((departing_1, departing_2), (8, 10)(5, \infty), 0)$
$e_1 = \quad ((crossed_1, departing_2), (0,5)(5,\infty), 1)$
$e_2 = \quad ((crossed_1, crossed_2), (8, 10)(5,\infty), 0)$
$\delta_C = \quad \{(e_o, pass_1, e_1), (e_1, pass_2, e_0)\}$
$e_o = \quad ((departing_1, departing_2), (8, 10)(5, \infty), 0),$
$E_m = \quad \{((crossed_1, crossed_2), (8, 10)(5, \infty), 0)\}$

Note: $pass_1$ is forced at $c_o$ in order to preempt the occurrence of $pass_1$, by setting the upper time bound $t_{pass_2} < r_{pass_1} = 8$.
Please note that the present model has 4 timed activities and 4 transitions versus 15 states and 18 transition using the state of the art.

**Synthesis example 2: A two-machine manufacturing cell**

Recall the manufacturing cell example of Section 4:

Machine1:

$$A_1 = (\Sigma_1, A_1, \delta_{A_1}, a_{o,1}, A_{m,1})$$

$A_1 = \quad \{processing_1\}$
$\delta_{A_1} = \quad \{(operational_1, work_1, operational_1)\}$
$a_{o,1} = \quad operational_1$
$A_{m,1} = \quad \{operational_1\}$

together with the following default lower and upper time bounds $(l_{work_1}, u_{work_1}) = (5,5)$. Furthermore, $work_1$ is assumed to be uncontrollable and non forcible.
Machine2:

$$A_2 = (\Sigma_2, A_2, \delta_{A_2}, a_{o,2}, A_{m,2})$$

$A_2 = \quad \{processing_2\}$
$\delta_{A_2} = \quad \{(operational_2, work_2, operational_2)\}$
$a_{o,2} = \quad operational_2$
$A_{m,2} = \quad \{operational_2\}$

together with the following default lower and upper time bounds $(l_{work_2}, u_{work_2}) = (2, \infty)$. Furthermore, $work_2$ is assumed to be controllable and forcible.

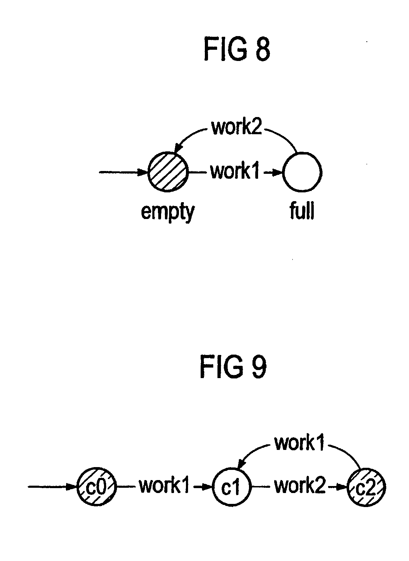

We impose a specification on the behavior of the two machines: the buffer of size one must not underflow or overflow. This implies that once the cell is in operation, the event $work_1$ must always be followed by the occurrence of the event $work_2$, and that the event $work_2$ must always be followed by the occurrence of the event $work_1$. This specification is embodied by the automaton **B** = **A**$_3$ and is shown in Figure 8.

$$A_3 = (\Sigma_3, A_3, \delta_{A_3} \, a_{o,3}, A_{m,3})$$

$A_3 =$ {emptybuf fer, fullbuf fer}
$\delta_{A3} =$ {(emptybuf fer, work$_1$, fullbuf fer),
(fullbuf fer, work$_2$, emptybuf fer)}
$a_{o,3} =$ emptybuf fer
$A_{m,3} =$ {emptybuf fer}

The corresponding supervisor or restricted timed behavior **C** of the two machines working concurrently within the specifications **B** = **A**$_3$ is obtained according to the supervisor synthesis procedure presented in Section 5, and is shown in Figure 9.

$$C = (\Sigma, C, \delta_C, c_o, C_m)$$

$\Sigma =$ {work$_1$, work$_2$}

$$C = \{c_o, c_1, c_2\}$$

where

$c_o =$ ((operational$_1$, operational$_2$), (5, 5)(2, ∞), emptybuf fer)
$c_1 =$ ((operational$_1$, operational$_2$), (5, 5)(0, ∞)), fullbuf fer)
$c_2 =$ ((operational$_1$, operational$_2$), (0, 5) (2, ∞), emptybuf fer)
$\delta_E =$ {($c_o$, work$_1$, $c_1$), ($c_1$, work$_2$, $c_2$),
($c_2$, work$_1$, $c_1$)}
$c_o =$ ((operational$_1$, operational$_2$), (5, 5)(2, ∞), emptybuf fer)
$C_m =$ {$c_o$, $c_2$}

Note: work$_2$ is disabled at $c_o$ and $c_2$, and is forced to occur at $c_1$, by setting the upper time bound $t_{work2} < r_{work1} = 5$.
Again, it is important to note that the present model has 3 timed activities and 3 transitions versus 24 states and 29 transition using the state of the art.

## 6 Discussion

The proposed approach to the modeling of timed state based processes, and the proposed approach to the synthesis of supervisors for timed state based processes offer important advantages over other approaches. These are now summarized below:

(i) very compact modeling in which the timing information on the occurrence of events is incorporated in the activities of the processes considered, and not explicitly in the form of *tick* transitions; this curbs the activity (state) explosion phenomenon encountered when large time bounds are considered in state of the art which use *ticks;*

(ii) very efficient model construction algorithm which does not require (a) the construction of all the submodels composing the timed state based processes considered, and (b) their subsequent composition into the final model: the construction approach thus curbs the activity (state) explosion phenomenon, by directly constructing the transition structures embodying the synchronous behavior of all component processes;

(iii) very efficient supervisor synthesis algorithm which (a) yields supervisors that are guaranteed by construction to be nonblocking and maximally permissive within given behavioral specifications; (b) does not require the construction of all the submodels composing the timed state based processes and behavioral specifications considered, and their subsequent composition into final processes and specifications models: the synthesis approach curbs the activity (state) explosion phenomenon, by directly constructing the transition structures embodying the synchronous behavior of all component processes and specifications restricted within the specifications considered.

**Claims**

1. Method for control of a process flow according to a specified behaviour with a computer having following features:

   a) at least a first and a second partial process of the process flow are described in fashion of a first and a second finite state machine;
   b) the specified behaviour is described as specificationautomat in fashion of a finite state machine;
   c) derived from the process-flow and the specificationautomat a finite state machine is being constructed as processautomat in that way, that beginning with an initial state of the process flow and continuing step by step for each respective further state of at least the first and the second finite state machine, it is analysed which state transitions are possible according to the description of the respective finite state machine and it is also checked which state transitions are allowed according to the specificationautomat, whereas only such state transitions are integrated in the processautomat which are possible and allowed;
   d) the process flow is being controlled by the computer using the processautomat.

2. Method according to claim 1 having following features:

   a) state transitions are discriminated at least in controllable and in uncontrollable state transitions;
   b) in case a faultstate is reached by a faulttransition during construction of the processautomat, where at least one uncontrollable state transition is possible, which isn't allowed by the specificationautomat then the construction process of the processautomat is resumed in a reanalysis at the model state before that transition which led to the faultstate, the beforefaultstate, and from there another state transition is being analysed.

3. Method according to one of the preceding claims having following features:

   a) at least the state transitions of the first and the second partial process of the process flow, as well as those of the specificationautomat are respectively provided with an upper and a lower time bound measured in time units, whereas the lower time bound defines the earliest possible point in time and the upper time bound the latest point in time when the state transition may happen and the time units are counted as soon as an initial state of a finite state machine is reached;
   b) in the initial state it is being started with at least one state transition, as initialtransition, which has the lowest lower time bound;
   c) a further state of the processautomat is being created, in furnishing all the possible state transitions which may start from this model state, the furtherstatetransitions, except the initialtransition, with new time bounds, in subtracting the upper time bound of the initialtransition from the former lower time bound of the respective state transition to build its new lower time bound and in subtracting the lower time bound of the initialtransition from the former upper time bound of the respective state transition to build its new upper time bound;
   d) negative time values are being set to zero;
   e) in case of the reanalysis of the faultstate at the beforefaultstate it is checked if there exists a controllable state transition, which can prevent the faultstate from occurring by variation of its time bounds and if this is possible at least one time bound of this state transition is changed accordingly.

4. Method according to claim 3,
   where at the beforefaultstate controllable state transition is started by variation of at least one time bound and/or the faulttransition is prevented from occurring by variation of at least one time bound.

5. Method according to one of the preceding claims, where the processautomat is at least constructed according to following features:

   a) in a first initialisation step six sets the new set, the final set, the bad set, the marker set, the nonblocking set, and the transitions set, all of which are initially empty are defined, with the initial timed activity

$$c_0 = (e_0, b_0)$$
$$= \left( (a_{0,1}, \cdots, a_{0,n}), \{(l_\sigma, u_\sigma) \text{ such that } \sigma \in \Sigma\}, (a_{0,n+1}, \cdots, a_{0,m}) \right)$$

and with

$$c = (e,b)$$

$$c = c_0 = \left( (a_1, \cdots, a_n), \{(r_\sigma, t_\sigma) \text{ such that } \sigma \in \Sigma\}, (a_{n+1}, \cdots, a_m) \right)$$

and where c is added to the new set and, if all the activities $a_i$, i = 1,...,n composing a are marker activities, i. e. $a_i \in A_{m,i}$, i = 1,...,n, e is added to the marker and nonblocking sets;
b) with

$$c = (e,b) = \left( (a_1, \cdots, a_n), \{(r_\sigma, t_\sigma) \text{ such that } \sigma \in \Sigma\}, (a_{n+1}, \cdots, a_m) \right)$$

for e the set of events $\sigma \in \Sigma$ such that $\delta_A(a,\sigma)$ is defined, referred to as the physically possible event set of c, is determined and for b the set of events $\sigma \in \Sigma$ such that $\delta_B(b,\sigma)$ is defined, referred to as the legal event set of c, is determined;
c) the timed activity

$$c = (e,b) = \left( (a_1, \cdots, a_n), \{(r_\sigma, t_\sigma) \text{ such that } \sigma \in \Sigma\}, (a_{n+1}, \cdots, a_m) \right)$$

is removed from the new set and if either all uncontrollable events $\sigma$ in the physically possible event set of c are contained in the legal event set of c, or if for all the uncontrollable events $\sigma$ in the physically possible event set of c which are not contained in the legal event set of c, there exists a forcible event $\beta$ which is both in the physically possible event set of c and in the legal event set of c, such that its lower time bound $r_\beta$ is strictly smaller than the lower time bound $r_\sigma$ of $\sigma$, c = (e,b) is placed in the final set of $\sigma$, otherwise c is placed in the bad set;
d) for all the timed activities c in the bad set, the corresponding timed activities c' in the final set from c, which may be reached in one transition $\sigma$, are determined and

- if the transition $\sigma$ leading to c from c' is uncontrollable and there does not exist a forcible event $\beta$ in both the physically possible event set of c and in the legal event set of c, such that its lower time bound $r_\beta$ is strictly smaller than the lower time bound $r_\sigma$ of $\sigma$, the activity c' is removed from the marker, nonblocking and final sets and added to the bad set, and the transition (c',$\sigma$,c) is removed from the transition set,
- if the transition $\sigma$ leading to c from c' is uncontrollable and there exists a forcible event $\beta$ in both the physically possible event set of c and in the legal event set of c such that its lower time bound $r_\beta$ is strictly smaller than the lower time bound $r_\sigma$ of $\sigma$, $u_\beta$ is set so that $u_\beta$ is strictly smaller than $r_\sigma$,
- if the transition $\sigma$ leading to c from c' is controllable, the transition (c',$\sigma$,c) is removed from the transition set, thus disabling it;

e) feature d is repeated until the number of timed activities in the bad set remains invariant.

6. Method according to claim 5, having following features:

a) for all the timed activities c in the final set and for all the events $\sigma$ contained in both the physically possible event set of c and in the legal event set of c, the corresponding timed activity $\delta(c,\sigma) = c'$ is computed with

$$c' = \left( a', \{(r'_\tau, t'_\tau) \text{ such that } \tau \in \Sigma\}, b' \right)$$

and with a' = $(a_1',...,a_n')$ and
b' = $(a_{n+1}',...,a_m')$ a' is computed as follows for i = 1,...,n as

$$a_i' = \begin{cases} \delta_{A_i}(a_i,\sigma) \text{ if } \delta_{A_i}(a_i,\sigma)! \\ a_i \text{ otherwise} \end{cases}$$

and for $\tau \neq \sigma$ the lower and upper time bounds $(r'_\tau, t'_\tau)$, $r \in \Sigma$ are computed as follows:

$$(r_\tau', t_\tau') = \begin{cases} (r_\tau - t_\sigma, t_\tau - r_\sigma) \text{ if } \delta_{A_i}(a,r)! \wedge \delta_{A_i}(a',r)! \\ (l_r, u_r) \text{ otherwise} \end{cases}$$

and for $\tau = \sigma$ are computed as

$$(r'_\tau, t'_\tau) = (l_r, u_r),$$

while b' for i= n+1,...,m is computed as

$$a_i' = \begin{cases} \delta_{A_i}(a_i,\sigma) \text{ if } \delta_{A_i}(a_i,\sigma)! \\ a_i \text{ otherwise} \end{cases};$$

b) and if c' is not already in either the final set or in the bad set, c' is added to the new set, and if all the activities $a_i$, i = 1,...,m composing a' and b' are marker activities, i.e. $a_i'$ $A_{m,i}$, i = 1,...,m, c' is added to the marker and nonblocking sets; and the transition $(c,\sigma,c')$ is added to the transitions set.

7. Method according to claim 5 and 6, where consecutively from claim 5 features b to e and from claim 6 features a and b are repeated until the new set is empty.

8. Method according to one of the claims 5 to 7, having following features:

   a) for all the timed activities *c* in the nonblocking set, the corresponding timed activities *c'* in the final set, from which *c* may be reached in one transition σ, are determined and *c'* is added to the nonblocking set, whereas feature a) is repeated until the number of timed activities in the nonblocking set remains invariant;
   b) all the timed activities c in the final set and not in the nonblocking set are removed from the marker and final sets and are placed in the bad set;
   c) for all the activities in the bad set, the corresponding timed activities *c'* in the final set from which c may be reached in one transition σ are determined and:

   - if the transition σ leading to *c* from *c'* is uncontrollable and there does not exist a forcible event β in both the physically possible event set of *c* and in the legal event set of *c*, such that its lower time bound $r_\beta$ is strictly smaller than the lower time bound $r_\sigma$ of σ, the activity c' is removed from the marker, nonblocking and final sets, and added to the bad set, and the transition $(c',\sigma,c)$ is removed from the transition set;
   - if the transition σ leading to *c* from *c'* is uncontrollable and there exists a forcible event β in both the physically possible event set of *c* and in the legal event set of *c*, such that its lower time bound $r_\beta$ is strictly smaller than the lower time bound $r_\sigma$ of σ, $u_\beta$ is set so that $u_\beta$ is strictly smaller than $r_\sigma$;

   d) feature c) is repeated until the number of timed activities in the bad set remains invariant.

9. Method according to one of the claims 5 to 8, where a graphical output is generated, in displaying all of the elements in the transition set together with their associated states.

10. Manufacturing process for a process control, where a computer is being build which executes one of the methods of the claims 1 to 9 which is applied as process control computer.

**Patentansprüche**

1. Verfahren zur Modellierung eines Prozeßflusses gemäß einem spezifizierten Verhalten mit einem Computer mit den folgenden Merkmalen:

   a) mindestens ein erster und ein zweiter teilweiser Prozeß des Prozeßflusses werden in Art eines ersten und eines zweiten Automaten beschrieben;

   b) das spezifizierte Verhalten wird als specificationautomat in Art eines Automaten beschrieben;

   c) abgeleitet aus dem Prozeßfluß und dem specificationautomat wird ein Automat als processautomat dergestalt konstruiert, daß beginnend mit einem Anfangszustand des Prozeßflusses und dann schrittweise weiter für jeden jeweiligen weiteren Zustand mindestens des ersten und des zweiten Automaten analysiert wird, welche Zustandsübergänge gemäß der Beschreibung des jeweiligen Automaten möglich sind, und außerdem geprüft wird, welche Zustandsübergänge gemäß dem specificationautomat zulässig sind, während nur solche Zustandsübergänge in den processautomat integiert werden, die möglich und zulässig sind;

   d) der Prozeßfluß wird durch den Computer unter Verwendung des processautomat gesteuert.

2. Verfahren nach Anspruch 1 mit den folgenden Merkmalen:

   a) Zustandsübergänge werden mindestens in steuerbare und unsteuerbare Zustandsübergänge unterschieden;

   b) falls ein faulttransition während der Konstruktion des processautomat ein faultstate erreicht, wobei mindestens ein unsteuerbarer Zustandsübergang möglich ist, der von dem specificationautomat nicht zugelassen wird, dann wird der Konstruktionsprozeß des processautomat vor dem Übergang, der zu dem faultstate führte, dem beforefaultstate, in einer Neuanalyse im Modellzustand wiederaufgenommen, und von dort aus ein anderer Zustandsübergang analysiert.

3. Verfahren nach einem der vorhergehenden Ansprüche mit den folgenden Merkmalen:

   a) mindestens die Zustandsübergänge des ersten und des zweiten teilweisen Prozesses des Prozeßflusses sowie die des specificationautomat werden jeweils mit einer oberen und einer unteren Zeitschranke versehen, die in Zeiteinheiten gemessenen werden, wohingegen die untere Zeitschranke den frühestmöglichen Zeitpunkt und die obere Zeitschranke den spätesten Zeitpunkt definiert, an dem der Zustandsübergang stattfinden kann, und die Zeiteinheiten gezählt werden, sobald ein Anfangszustand eines Automaten erreicht ist;

   b) im Anfangszustand wird es mit mindestens einem Zustandsübergang als initialtransition gestartet, der die niedrigste untere Zeitschranke aufweist;

   c) ein weiterer Zustand des processautomat wird erzeugt durch Bereitstellung aller möglichen Zustandsübergänge, die von diesem Modellzustand aus starten können, den furtherstatetransitions, mit Ausnahme des initialtransition, mit neuen Zeitschranken, durch Subtraktion der oberen Zeitschranke des initialtransition von der ehemaligen unteren Zeitschranke des jeweiligen Zustandsübergangs, um dessen neue untere Zeitschranke aufzubauen, und durch Subtraktion der unteren Zeitschranke des initialtransition von der ehemaligen oberen Zeitschranke des jeweiligen Zustandsübergangs, um dessen neue obere Zeitschranke aufzubauen;

   d) negative Zeitwerte werden auf Null gesetzt;

   e) im Fall der Neuanalyse des faultstate am beforefaultstate wird geprüft, ob es einen steuerbaren Zustandsübergang gibt, wodurch verhindert werden kann, daß das faultstate auftritt, durch Variation seiner Zeitgrenzen, und wenn dies möglich ist, wird mindestens eine Zeitgrenze dieses Zustandsübergangs entsprechend geändert.

4. Verfahren nach Anspruch 3, wobei im beforefaultstate ein Steuerbarszustandsübergang gestartet wird, indem mindestens eine Zeitgrenze variiert wird, und/oder es wird verhindert, daß das faultstate auftritt, durch Variation mindestens einer Zeitgrenze.

5. Verfahren nach einem der vorhergehenden Ansprüche, wobei das processautomat mindestens gemäß den folgenden Merkmalen konstruiert wird:

a) in einem ersten Initialisierungsschritt werden sechs Mengen, die neue Menge, die letzte Menge, die schlechte Menge, die Markierermenge, die nichtblockierende Menge und die Übergangsmenge, die alle, anfangs leer, mit der folgenden anfänglichen zeitgesteuerten Aktivität definiert:

$$c_0 = (e_0, b_0),$$
$$= ((a_{0,1}, \ldots, a_{0,n}), \{(l_\sigma, u_\sigma) \text{ für alle } \sigma \in \Sigma\}, (a_{0,n+1}, \ldots, a_{0,m}))$$

und mit

$$c = (e, b)$$

$$c = c_0 =$$
$$((a_1, \ldots, a_n), \{(r_\sigma, t_\sigma) \text{ für alle } \sigma \in \Sigma\}, (a_{n+1}, \ldots, a_m))$$

und wobei c zu der neuen Menge hinzugefügt wird, und wenn alle Aktivitäten $a_i$, i = 1, ..., n, aus denen a besteht, Markiereraktivitäten sind, d.h. $a_i \in A_{m,i}$, i = 1, ..., n, gilt, e zu der Markierer- und der nichtblockierenden Menge hinzugefügt wird;

b) wobei

$$c = (e, b)$$
$$= ((a_1, \ldots, a_n), \{(r_\sigma, t_\sigma) \text{ für alle } \sigma \in \Sigma\}, (a_{n+1}, \ldots, a_m))$$

mit e gleich der Menge von Ereignissen $\sigma \in \Sigma$, für die $\delta(a,\sigma)$ definiert ist, als die physisch mögliche Ereignismenge von c bezeichnet, bestimmt wird und mit b gleich der Menge von Ereignissen $\sigma \in \Sigma$, für die $\delta_B(b,\sigma)$ definiert ist, als die legale Ereignismenge von c bezeichnet, bestimmt wird;

c) die zeitgesteuerte Aktivität

$$c = (e, b)$$
$$= ((a_1, \ldots, a_n), \{(r_\sigma, t_\sigma) \text{ für alle } \sigma \in \Sigma\}, (a_{n+1}, \ldots, a_m))$$

wird aus der neuen Menge entfernt, wenn entweder alle unsteuerbaren Ereignisse σ in der physisch möglichen Ereignismenge von c in der legalen Ereignismenge von c enthalten sind oder wenn für alle unsteuerbaren Ereignisse σ in der physisch möglichen Ereignismenge von c , die nicht in der legalen Ereignismenge von c enthalten sind, ein erzwingbares Ereignis β existiert, das sich sowohl in der physisch möglichen Ereignismenge von c als auch in der legalen Ereignismenge von c befindet, dergestalt, daß seine untere Zeitschranke $r_\beta$ streng kleiner als die untere Zeitschranke $r_\sigma$ von σ ist, wird c = (e, b) in der letzten Menge von σ plaziert, andernfalls wird c in der schlechten Menge plaziert;

d) für alle zeitgesteuerten Aktivitäten c in der schlechten Menge werden die entsprechenden zeitgesteuerten Aktivitäten c' in der letzten Menge aus c, die bei einem Übergang σ erreicht werden können, bestimmt und

- wenn der von c zu c' führende Übergang σ unsteuerbar ist und es weder in der physisch möglichen Ereignismenge von c noch in der legalen Ereignismenge von c ein erzwingbares Ereignis β gibt, dergestalt, daß seine untere Zeitschranke $r_\beta$ streng kleiner als die untere Zeitschranke $r_\sigma$ von σ ist, wird die Aktivität c' aus der Markierer-, der nichtblockierenden und der letzten Menge entfernt und zu der schlechten Menge hinzugefügt, und der Übergang (c',σ,c) wird aus der Übergangsmenge entfernt,

- wenn der von c zu c' führende Übergang σ unsteuerbar ist und es sowohl in der physisch möglichen Ereignismenge von c als auch in der legalen Ereignismenge von c ein erzwingbares Ereignis β gibt, dergestalt, daß seine untere Zeitschranke $r_\beta$ streng kleiner als die untere Zeitschranke $r_\sigma$ von σ ist, wird $u_\beta$ streng kleiner als $r_\sigma$ gesetzt,

- wenn der von c zu c' führende Übergang σ steuerbar ist, wird der Übergang (c',σ,c) aus der Übergangsmenge entfernt und dadurch gesperrt;

e) Merkmal d wird wiederholt, bis die Anzahl von zeitgesteuerten Aktivitäten in der schlechten Menge invariant bleibt.

**6.** Verfahren nach Anspruch 5 mit den folgenden Merkmalen:

a) für alle zeitgesteuerten Aktivitäten c in der letzten Menge und für alle Ereignisse σ, die sowohl in der physisch möglichen Ereignismenge von c als auch in der legalen Ereignismenge von c enthalten sind, wird die entsprechende zeitgesteuerte Aktivität δ(c,σ) = c' berechnet mit

$$c' = \left(a', \left\{(r'_\tau, t'_\tau) \text{ für alle } \tau \in \Sigma\right\}, b'\right),$$

und mit

$$a' = (a'_1, ..., a'_n)$$

und

$$b' = (a_{n+1}', ..., a'_m)$$

a' wird für i = 1, ..., n folgendermaßen berechnet:

$$a'_i = \begin{cases} \delta_{A_i}(a_i, \sigma) \text{ für } \delta_{A_i}(a_i, \sigma)! \\ a_i \text{ andernfalls} \end{cases}$$

und für τ ≠ σ werden die untere und die obere Zeitschranke $(r'_\tau, t'_\tau)$, r ∈ Σ, folgendermaßen berechnet:

$$(r'_\tau, t'_\tau) = \begin{cases} (r_\tau - t_\sigma, t_\tau - r_\sigma) \text{ für } \delta_{A_i}(a, r)! \wedge \delta_{A_i}(a', r)! \\ (l_r, u_r) \text{ andernfalls} \end{cases}$$

und für $\tau = \sigma$ folgendermaßen:

$$(r'_\tau, t'_\tau) = (l_r, u_r),$$

während b' für i = n+1, ..., m folgendermaßen berechnet wird:

$$a'_i = \begin{cases} \delta_{A_i}(a_i, \sigma) \text{ für } \delta_{A_i}(a_i, \sigma)! \\ a_i \text{ andernfalls} \end{cases} ;$$

b) und wenn sich c' nicht bereits entweder in der letzten Menge oder in der schlechten Menge befindet, wird c' zu der neuen Menge hinzugefügt, und wenn alle Aktivitäten $a_i$, i = 1, ..., m, aus denen a' und b' bestehen, Markiereraktivitäten sind, d.h. $a'_i A_{m,i}$, i = 1, ..., m, wird c' zu der Markierer- und der nichtblockierenden Menge hinzugefügt; und der Übergang (c',σ,c) wird zu der Übergangsmenge hinzugefügt.

7. Verfahren nach einem der Ansprüche 5 und 6, wobei aufeinanderfolgend von Anspruch 5 die Merkmale b bis e und von Anspruch 6 die Merkmale a und b wiederholt werden, bis die neue Menge leer ist.

8. Verfahren nach einem der Ansprüche 5 bis 7 mit den folgenden Merkmalen:

a) für alle zeitgesteuerten Aktivitäten c in der nichtblockierenden Menge werden die entsprechenden zeitgesteuerten Aktivitäten c' in der letzten Menge, von denen aus c in einem Übergang σ erreicht werden kann, bestimmt, und c' wird zu der nichtblockierenden Menge hinzugefügt, wohingegen Merkmal a) wiederholt wird, bis die Anzahl von zeitgesteuerten Aktivitäten in der nichtblockierenden Menge invariant bleibt;

b) alle zeitgesteuerten Aktivitäten c in der letzten Menge und nicht in der nichtblockierenden Menge werden aus der Markierer- und der letzten Menge entfernt und in der schlechten Menge plaziert;

c) für alle Aktivitäten in der schlechten Menge werden die entsprechenden zeitgesteuerten Aktivitäten c' in der letzten Menge, von denen aus c in einem Übergang σ erreicht werden kann, bestimmt und:

- wenn der von c zu c' führende Übergang σ unsteuerbar ist und es weder in der physisch möglichen Ereignismenge von c noch in der legalen Ereignismenge von c ein erzwingbares Ereignis β gibt, dergestalt, daß seine untere Zeitschranke $r_\beta$ streng kleiner als die untere Zeitschranke $r_\sigma$ von σ ist, wird die Aktivität c' aus der Markierer-, der nichtblockierenden und der letzten Menge entfernt und zu der schlechten Menge hinzugefügt, und der Übergang (c',σ,c) wird aus der Übergangsmenge entfernt,

- wenn der von c zu c' führende Übergang σ unsteuerbar ist und es sowohl in der physisch möglichen Ereignismenge von c als auch in der legalen Ereignismenge von c ein erzwingbares Ereignis β gibt, dergestalt, daß seine seine untere Zeitschranke $r_\beta$ streng kleiner als die untere Zeitschranke $r_\sigma$ von σ ist, wird $u_\beta$ so gesetzt, daß $u_\beta$ streng kleiner als $r_\sigma$ ist;

d) Merkmal c) wird wiederholt, bis die Anzahl von zeitgesteuerten Aktivitäten in der schlechten Menge invariant bleibt.

9. Verfahren nach einem der Ansprüche 5 bis 8, wobei eine graphische Ausgabe erzeugt wird, durch Anzeigen aller Elemente in der Übergangsmenge zusammen mit ihren zugeordneten Zuständen.

**10.** Herstellungsprozeß für eine Prozeßsteuerung, wobei ein Computer aufgebaut wird, der eines der Verfahren nach Anspruch 1 bis 9 ausführt und als Prozeßsteuercomputer angewandt wird.

**Revendications**

**1.** Méthode pour la commande d'un déroulement de processus selon un comportement spécifié avec un ordinateur, ayant les caractéristiques suivantes :

a) au moins un premier et un deuxième processus partiel du déroulement de processus sont décrits à la manière d'une première et d'une deuxième machine à états finis ;
b) le comportement spécifié est décrit comme *automate de spécification* à la manière d'une machine à états finis ;
c) dérivée du déroulement de processus et de l'*automate de spécification*, une machine à états finis est construite comme *automate de processus* de manière à ce que, commençant avec un état initial du déroulement de processus et poursuivant pas à pas pour chaque autre état respectif d'au moins la machine à premier et à deuxième état fini, on analyse quelles sont les transitions d'état possibles selon la description de la machine à états finis respective et on contrôle aussi quelles transitions d'état sont autorisées selon l'*automate de spécification,* en conséquence de quoi seules les transitions d'état qui sont possibles et autorisées sont intégrées dans l'*automate de processus* ;
d) le déroulement de processus est piloté par l'ordinateur à l'aide de l'*automate de processus.*

**2.** Méthode selon la revendication 1, ayant les caractéristiques suivantes :

a) des transitions d'état sont discriminées au moins en transitions d'état contrôlables et non contrôlables ;
b) au cas où un *état faux* est atteint par une *transition fausse* pendant la construction de l'*automate de processus,* où au moins une transition d'état non contrôlable est possible, ce qui n'est pas autorisé par l'*automate de spécification,* le processus de construction de l'*automate de processus* est alors repris dans une *nouvelle analyse* à l'état de modèle avant la transition qui conduit à l'*état faux,* l'*avant état faux,* et de là une autre transition d'état est analysée.

**3.** Méthode selon l'une quelconque des revendications précédentes ayant les caractéristiques suivantes :

a) au moins les transitions d'état du premier et du deuxième processus partiel du déroulement de processus, ainsi que celles de l'*automate de spécification* sont dotées respectivement d'une limite de temps supérieure et inférieure mesurées en unités de temps, alors que la limite de temps inférieure définit le point le plus précoce possible dans le temps, et la limite de temps supérieure le point le plus tardif dans le temps auxquels la transition d'état peut survenir et les unités de temps sont comptées dès qu'un état initial d'une machine à états finis est atteint ;
b) dans l'état initial, on commence avec au moins une transition d'état, comme *transition initiale,* qui a la limite de temps inférieure la plus basse ;
c) un autre état de l'*automate de processus* est créé, en fournissant toutes les transitions d'état possibles qui peuvent démarrer de cet état de modèle, les *transitions d'état ultérieures, à* l'exception des *transitions initiales,* avec de nouvelles limites de temps, en soustrayant la limite de temps supérieure de la *transition initiale* de la limite de temps inférieure de la transition d'état respective pour construire sa nouvelle limite de temps inférieure et en soustrayant la limite de temps inférieure de la *transition initiale* de la limite de temps supérieure précédente de la transition d'état respective pour construire sa nouvelle limite de temps supérieure ;
d) les valeurs de temps négatives sont mises à zéro ;
e) en cas de nouvelle analyse de l'*état en défaut* à l'*état avant défaut,* on contrôle s'il existe une transition d'état contrôlable, qui peut empêcher l'*état en défaut* de se produire par variation de ses limites de temps et si c'est possible, au moins une limite de temps de cette transition d'état est modifiée en conséquence.

**4.** Méthode selon la revendication 3, dans laquelle à l'*état avant défaut* la transition d'état contrôlable est démarrée en modifiant au moins une limite de temps et/ou la *transition en défaut* est empêchée de se produire en modifiant au moins une limite de temps.

**5.** Méthode selon l'une quelconque des revendications précédentes, dans laquelle l'*automate de processus* est au moins construit selon les caractéristiques suivantes :

a) dans une première étape d'initialisation, six ensembles : le nouvel ensemble, l'ensemble final, l'ensemble faux, l'ensemble de marqueurs, l'ensemble à accès non bloquant, et l'ensemble de transitions, dont tous sont vides à l'origine, sont définis, avec l'activité programmée initiale

$$c_0 = (e_0, b_0)$$

$$= ((a_{0,1}, ..., a_{0,n}),\{l_\sigma, u_\sigma) \text{ tel que } \sigma \in \Sigma\}, (a_{0,n+1}, ..., a_{0,m})$$

et avec

$$c = (e, b)$$

$$c = c_0 = ((a_1,..., a_n), \{(r_\sigma, t_\sigma) \text{ tel que } \sigma \in \Sigma\}, (a_{n+1}, ..., a_m))$$

et où $c$ est ajouté au nouvel ensemble et, si toutes les activités $a_i$, $i = 1, ..., n$ constituant $a$ sont des activités de marqueurs, c'est-à-dire $a_i \in A_{m, i}$, $i = 1, ..., n$, $e$ est ajouté aux ensembles de marqueurs et à accès non bloquant ;
b) avec

$$c = (e, b) = ((a_1,..., a_n), \{(r_\sigma, t_\sigma) \text{ tel que } \sigma \in \Sigma\}, (a_{n+1}, ..., a_m))$$

pour e, l'ensemble d'événements $\sigma \in \Sigma$ tel que $\delta_A (a, \sigma)$ soit défini, désigné comme l'ensemble d'événements physiquement possibles de c, est déterminé et pour b, l'ensemble d'événements $\sigma \in \Sigma$ tel que $\delta_B (b, \sigma)$ soit défini, désigné comme l'ensemble d'événements légal de c, est déterminé ;
c) l'activité programmée

$$c = (e, b) = ((a_1,..., a_n), \{(r_\sigma, t_\sigma) \text{ tel que } \sigma \in \Sigma\}, (a_{n+1},..., a_m))$$

est supprimée du nouvel ensemble et si, soit tous les événements non contrôlables $\sigma$ dans l'ensemble d'événements physiquement possibles de $c$ sont contenus dans l'ensemble d'événements légaux de $c$, soit pour tous les événements non contrôlables $\sigma$ dans l'ensemble d'événements physiquement possibles de $c$ qui ne sont pas contenus dans l'ensemble d'événements légaux de $c$, il existe un événement forçable $\beta$ qui est à la fois dans l'ensemble d'événements physiquement possibles de $c$ et dans l'ensemble d'événements légaux de $c$, de telle sorte que sa limite de temps inférieure $r_\beta$ soit strictement inférieure à la limite de temps inférieure $r_\sigma$ de $\sigma$, c = (e, b) est placé dans l'ensemble final de $\sigma$ ; sinon, c est placé dans l'ensemble faux ;
d) pour toutes les activités programmées $c$ dans l'ensemble faux, les activités programmées $c'$ correspondantes dans l'ensemble final à partir de $c$ qui peuvent être atteintes dans une transition $\sigma$, sont déterminées et

- si la transition $\sigma$ menant à $c$ à partir de $c'$ n'est pas contrôlable et qu'il n'existe pas d'événement forçable $\beta$ à la fois dans l'ensemble d'événements physiquement possibles de $c$ et dans l'ensemble d'événements légaux de $c$, de telle sorte que sa limite de temps inférieure $r_\beta$ soit strictement inférieure à la limite de temps inférieure $r_\sigma$ de $\sigma$, l'activité $c'$ est supprimée des ensembles de marqueurs, à accès non bloquant et final et est ajoutée à l'ensemble faux, et la transition (c', $\sigma$, c) est supprimée de l'ensemble de transitions,
- si la transition $\sigma$ menant à $c$ à partir de $c'$ n'est pas contrôlable et qu'il existe un événement forçable $\beta$ à la fois dans l'ensemble d'événements physiquement possibles de $c$ et dans l'ensemble d'événements légaux de $c$, de telle sorte que sa limite de temps inférieure $r_\beta$ soit strictement inférieure à la limite de temps inférieure $r_\sigma$ de $\sigma$, $u_\beta$ est défini de telle sorte que $u_\beta$ soit strictement inférieur à $r_\sigma$,
- si la transition $\sigma$ menant à $c$ à partir de c' est contrôlable, la transition (c', $\sigma$, c) est supprimée de l'ensemble de transitions, donc en l'invalidant ;

e) la caractéristique d est répétée jusqu'à ce que le nombre d'activités programmées dans l'ensemble faux reste invariant.

**6.** Méthode selon la revendication 5, ayant les caractéristiques suivantes :

a) pour toutes les activités programmées $c$ dans l'ensemble final et pour tous les événements $\sigma$ contenus à la fois dans l'ensemble d'événements physiquement possibles de $c$ et dans l'ensemble d'événements légaux de $c$, l'activité programmée correspondante $\delta(c, \sigma) = c'$ est calculée avec

$$c' = (a', \{(r'_\tau, t'_\tau) \text{ tel que } \tau \in \Sigma\}), b') \text{ et avec } a' = (a'_1, ..., a'_n)$$

et

$$b' = (a_{n+1'}, ...., a'_m)$$

$a'$ est calculé comme suit :
pour $i = 1,..., n$ comme

$$a'_i = \begin{cases} \delta_{A_i}(a_i, \sigma) & si\ \delta_{A_i}(a_i, \sigma)! \\ a_i & autrement \end{cases}$$

et pour $\tau \neq \sigma$, les limites de temps supérieures et inférieures $(r'_\tau, t'_\tau)$, $\tau \in \Sigma$ sont calculées comme suit :

$$(r'_\tau, t'_\tau) = \begin{cases} [r_\tau - t_\sigma, t_\tau - r_\sigma] & si\ \delta_{A_i}(a, \tau)! \wedge \delta_{A_i}(a', \tau)! \\ (l_\tau, u_\tau) & autrement \end{cases}$$

et pour $\tau = \sigma$, elles sont calculées comme suit :

$$(r'_\tau, t'_\tau) = (l_\tau, u_\tau).$$

tandis que pour i = n + 1, ..., m, b' est calculé comme suit :

$$a'_i = \begin{cases} \delta_{A_i}(a_i, \sigma) & si\ \delta_{A_i}(a_i, \sigma)! \\ a_i & autrement \end{cases}$$

b) et si $c'$ n'est pas encore dans l'ensemble final ou dans l'ensemble faux, $c'$ est ajouté au nouvel ensemble, et si toutes les activités ai, $i = 1, ..., m$ composant $a'$ et $b'$ sont des activités de marqueurs, c'est-à-dire $a'_i \in A_{m,i}$, $i = 1, ..., m$, $c'$ est ajouté aux ensembles de marqueurs et à accès non bloquant ; et la transition $(c, \sigma, c')$ est ajoutée à l'ensemble de transitions.

**7.** Méthode selon les revendications 5 et 6, dans laquelle les caractéristiques b à e de la revendication 5 et les caractéristiques a et b de la revendication 6 sont consécutivement répétées jusqu'à ce que le nouvel ensemble soit vide.

**8.** Méthode selon l'une quelconque des revendications 5 à 7, ayant les caractéristiques suivantes :

a) pour toutes les activités programmées $c$ dans l'ensemble à accès non bloquant, les activités programmées correspondantes $c'$ dans l'ensemble final, à partir duquel $c$ peut être atteint dans une transition $\sigma$ sont déterminées et c' est ajouté à l'ensemble à accès non bloquant, tandis que la caractéristique a) est répétée jusqu'à ce que le nombre d'activités programmées dans l'ensemble à accès non bloquant reste invariant ;
b) toutes les activités programmées $c$ dans l'ensemble final et non dans l'ensemble à accès bloquant sont supprimées des ensembles de marqueurs et final et sont placées dans l'ensemble faux ;

c) pour toutes les activités dans l'ensemble faux, les activités programmées *c'* correspondantes, dans l'ensemble final à partir duquel *c* peut être atteint dans une transition σ, sont déterminées et :

- si la transition σ menant à *c* à partir de *c'* n'est pas contrôlable et qu'il n'existe pas d'événement forçable β à la fois dans l'ensemble d'événements physiquement possibles de *c* et dans l'ensemble d'événements légaux de *c*, de telle sorte que sa limite de temps inférieure $r_β$ soit strictement inférieure à la limite de temps inférieure $r_σ$ *de* σ, l'activité *c'* est supprimée des ensembles de marqueurs, à accès non bloquant et final et est ajoutée à l'ensemble faux, et la transition (c', σ, c) est supprimée de l'ensemble de transitions,
- si la transition σ menant à *c* à partir de *c'* n'est pas contrôlable et qu'il existe un événement forçable β à la fois dans l'ensemble d'événements physiquement possibles de *c* et dans l'ensemble d'événements légaux de *c,* de telle sorte que sa limite de temps inférieure $r_β$ soit strictement inférieure à la limite de temps inférieure $r_σ$ de $σ_1$ $u_β$ est défini de telle sorte que $u_β$ soit strictement inférieur à $r_σ$;

d) la caractéristique c) est répétée jusqu'à ce que le nombre d'activités programmées dans l'ensemble faux reste invariant.

9. Méthode selon l'une quelconque des revendications 5 à 8, dans laquelle une sortie graphique est générée, en affichant tous les éléments dans l'ensemble de transitions conjointement avec leurs états associés.

10. Procédé de fabrication pour une commande de processus, dans lequel un ordinateur est construit pour exécuter une des méthodes des revendications 1 à 9 qui est appliquée comme ordinateur de commande de processus.

# FIG 1

# FIG 2

# FIG 3

departing1    crossed1

pass1→

departing2    crossed2

pass2→

e0 — pass1→ e2

pass2

pass2

e1 — pass1→ e3

# FIG 4

pass1

0 — pass2→ 1

# FIG 5

c0 — pass2→ c1 — pass1→ c3

# FIG 6

# FIG 7

# FIG 8

# FIG 9